# EUROPEAN PATENT APPLICATION

(11) **EP 1 522 865 A1**
(43) Date of publication of application: **13.04.2005**
(21) Application number: 03450225.2
(22) Date of filing: 07.10.2003
(51) Int. Cl.: G01R 31/36

(54) **Battery powered device**

(71) Applicant: AKG Acoustics GmbH, 1230 Wien (AT)
(72) Inventor: Brenner, Erich, 2212 Grossengersdorf (AT)
(74) Representative: Patentanwälte BARGER, PISO & PARTNER

(57) **Abstract**

The invention concerns a battery-powered device (1) with at least one battery shaft (2) for two batteries (9) or storage batteries having device regulation electronics (4) to determine and display the state of charging of the batteries or storage batteries inserted in the battery shaft, in which a center contact (8) is provided in battery shaft (2), which is used to measure the individual voltages of batteries or storage batteries.

The invention is characterized in that during the use of a battery pack having regulation electronics, data transfer occurs with the battery-powered device (1) via center contact (8).

## Description

This invention concerns battery powered devices that are operated with at least two ordinary batteries or rechargeable batteries, having a device to determine and display the charging state of the batteries or rechargeable batteries, respectively in whose battery shaft a center contact is provided that is used to measure the individual voltages of the batteries.

A number of devices are supplied with current by such power supplies. These include digital cameras, camcorders, dictation machines, wireless microphones, and many more. In most of these devices it is important or absolutely essential to know in which state its power supply is found in order to be able to estimate whether it can deliver the expected power. Various devices and methods have therefore already been developed to achieve this objective. One solution is from AT 408 280 B, corresponding to US 6,344,730 A, whose contents are included in the present application as a reference. This already known solution, which is based on knowledge of the relation between voltage and charge of the power supply, has worked in ordinary batteries, but invariably has led to problems because of the extremely different types and qualities of rechargeable batteries, also called storage batteries, since such a relation is not known with sufficient reliability or is not predictable for such power supplies.

In addition to batteries, there are also so-called battery packs which, contrary to their name, do not have ordinary batteries but at least one, generally two or more, rechargeable batteries and also have an electronic circuit with which a variety of operating parameters are monitored and stored, in which these data can be queried by special contacts on the battery pack and on the device, and which therefore require specially designed battery shafts.

Special charging devices, so-called chargers, which are connected either to the battery-powered device in which the storage batteries of battery packs are found or which are inserted into the storage batteries or battery packs removed from the device, also exist in most cases for such devices. There are also devices in which several battery packs or storage batteries can be inserted (subsequently, this distinction is only made where such distinction is necessary), and there are also chargers that can simultaneously charge storage batteries that are inserted in them as well as storage batteries that are situated in the device connected to the charger. In different ways, during avoidance of additional cables and additional contacts are extremely advantageous with respect to the usability of different power supplies in such devices.

Subsequently, only two batteries or storage batteries and one battery pack or a battery shaft will be spoken of, but naturally multiples of this arrangement are possible and can easily be devised with the corresponding space availability and the corresponding power demand by one skilled in the art and with knowledge of the invention. The above wording is used in the following description merely for reasons of easier understanding.

The invention is further described below with reference to the drawings, which purely schematically show a practical example of the invention. Figure 1 shows a general block diagram, Figures 2 to 5 show four different operating states with a battery-powered device according to the invention, and Figure 6 shows the situation of a charger with the battery pack inserted.

In the drawings, the lines provided to transmit analog signals or power are shown as dashed lines, the lines designed to transmit the digital signal are dotted lines, and the lines used to transmit both types of signals are shown as continuous lines.

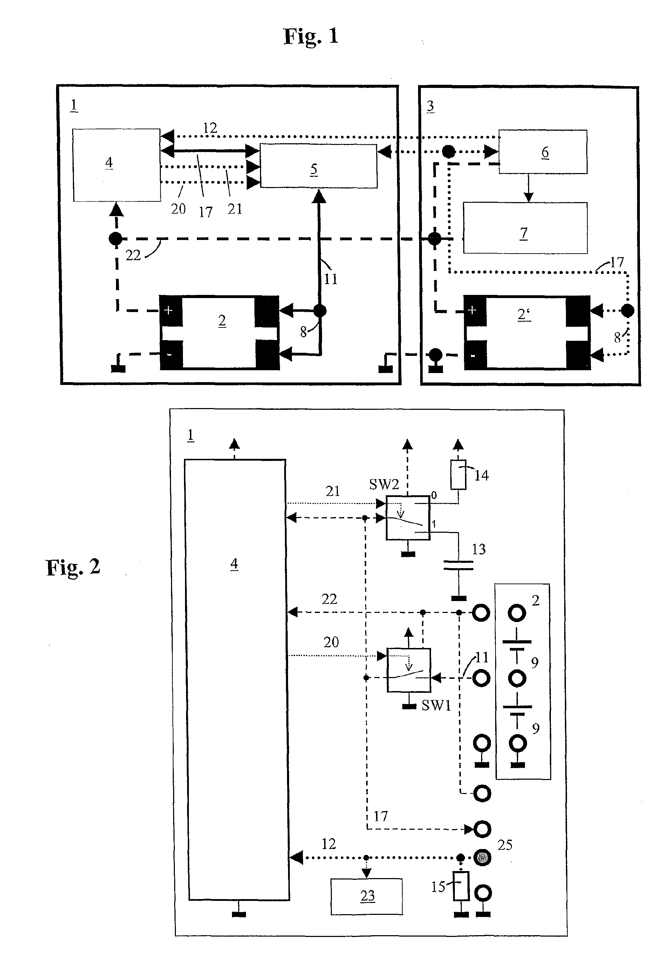

Figure 1 purely schematically shows a block diagram of a battery-powered device 1 according to the invention, with a battery shaft 2 and attached charger 3. As stated above, ordinary batteries, storage (rechargeable) batteries, or a so-called battery pack can be inserted into battery shaft 2. The device 1 has control and regulation electronics 4, which have a so-called line regulation 5, but which is drawn as its own part.

The charger 3 has an electronic control and regulation circuit 6 that controls or regulates a current or voltage source 7. The charger 3 also ordinarily has a battery slit 2', which naturally has an insertion size geometrically corresponding to the battery slit or shaft 2.

The charger 3 is connectable or connected to the device 1 via any contact connection, with this connection permitting both the supply of charging current to battery shaft 2 and data exchange between the regulation electronics 6 of charger 3 and the regulation electronics 4 of the device 1. Such data exchange, as mentioned above, is already known in chargers of the prior art but not in conjunction with the use of the center contact as a battery pack according to the invention.

The device 1 has its own current consumer, which is not shown in the present case for reasons of clarity; this can be a camera, a microphone, a headset, a dictation machine, etc. The number of applications for battery-powered devices is large and is still increasing.

Figure 1, also purely schematically, shows the lines and components of device 1 and charger 3 essential for the invention: starting from battery section 2 of the device 1, there is a connection of the negative pole to ground and a connection that conducts the energy of the batteries from the positive pole to the device regulation electronics 4. In the operating state detected in Figure 1, there is also a connection to a controlled current source 7, to regulation electronics 6 of charger 3, and to the positive pole of battery slit 2' of charger 3. The voltage of the batteries, storage batteries, or the battery pack is also monitored via this connection. In the depicted state (charger 3 with the battery-drive device 1 connected), the insertion of a battery pack into battery slit 2' of the charger is prevented by a mechanical blocking device and vice-versa, so that two battery packs that might have to be treated differently cannot be contacted simultaneously. Other solutions are naturally easily to devise for one skilled in the art and with knowledge of the invention.

There is also an electrical connection between the center contact 8 -- which, because of the possibility of using individual batteries or storage batteries, is shown as a double contact, but galvanically corresponds to a single contact -- and the line regulation 5, which is controlled by the device regulation electronics 4, but spatially can naturally also be a part of it. A line, called center connection 11, transmits, depending on the prevailing operating conditions, either digital signals or analog signals and is therefore shown as a solid line.

A digital connection that transmits only data exists between the line regulation 5, the charger regulation electronics 6, and the center contact 8' of charger 2. Finally, in the depicted practical example, which represents a preferred variant, there is also a direct connection, referred to as command connection 12, or "device start", between charger regulation electronics 6 and the device regulation electronics 4. In this manner it is possible for the charger regulation electronics 6 to inform the device regulation electronics 4 that the device was inserted into the charger (or connected to it) and the device is then engaged from the charger or the type of operation of the device 1 is adapted.

The terms "device regulation electronics" and "charger regulation electronics" are used in the description and the claims, although at least in some types of operation a control mode rather than a regulation mode is present; this wording was introduced for easier understanding and does not represent a technical or other form of restriction.

The individual Figures 2 to 6 are explained briefly below, but the function and the corresponding operating state of the individual configurations are only taken up later:

Figure 2 shows -- in somewhat more detail than in Figure 1, but still schematically -- a device 1 of batteries 9 (two cells) in battery shaft 2. The center voltage is fed via a switch SW1, which is part of line regulation 5, to device regulation electronics 4 via line 17. A switch SW2, which is also a part of the line regulation 5, is connected to a capacitor 13, which serves as buffer for the ADC. In addition, a pull-up resistor 14, which is required for the data interface, is switched off in order to avoid distortion of the ADC measurement. The contacts of connection 25 to charger 3 are naturally open in this configuration.

Since batteries 9 (two cells) are inserted, a center voltage is obtained that lies between 0.5 V and 2 V so that the "battery operation" is acknowledged.

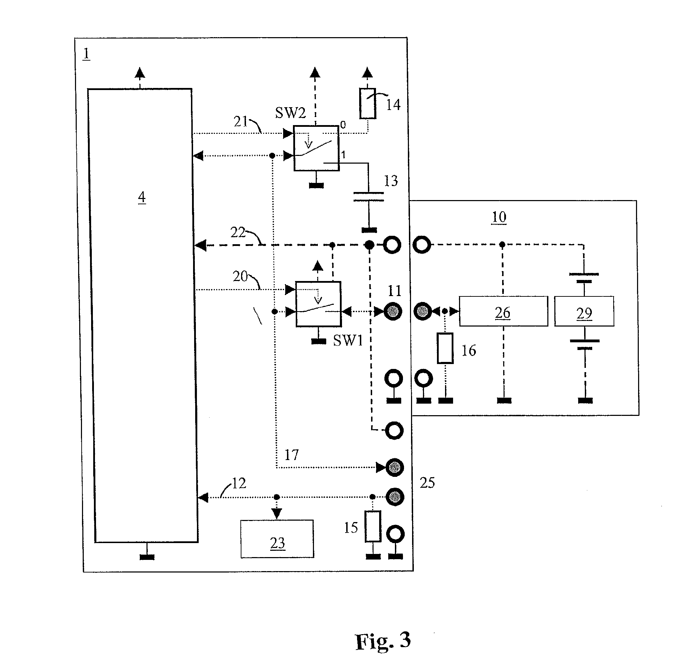

Figure 3 shows a situation with battery pack 10 inserted, which is detected by the device regulation electronics 4 by the low center voltage of less than 0.5 V, and as a result allows the flow of digital data through center line 11. The data signal of the charge-regulation-ONE-wire-interfaces lies at the center contacts, which is switched via SW1 through the device regulation electronics 4 via line 17. SW2 switches on the pull-up resistor 14, which generates the high level of the open-collector-bus system. The capacitor 13 serving as a buffer for the ADC is switched off so as not to delay the data protocol. A pull-down resistor 16 is provided in battery pack 10, which means that the center voltage measured by device 1 lies below 0.5 V and that defined states prevail in the battery pack. The regulation electronics 26 found in battery pack 10 functions in the slave mode and reacts only to a query. Battery pack 10 is protected from the aftermath of short circuits by a fuse 29 which is preferably located between the two storage batteries of the battery pack.

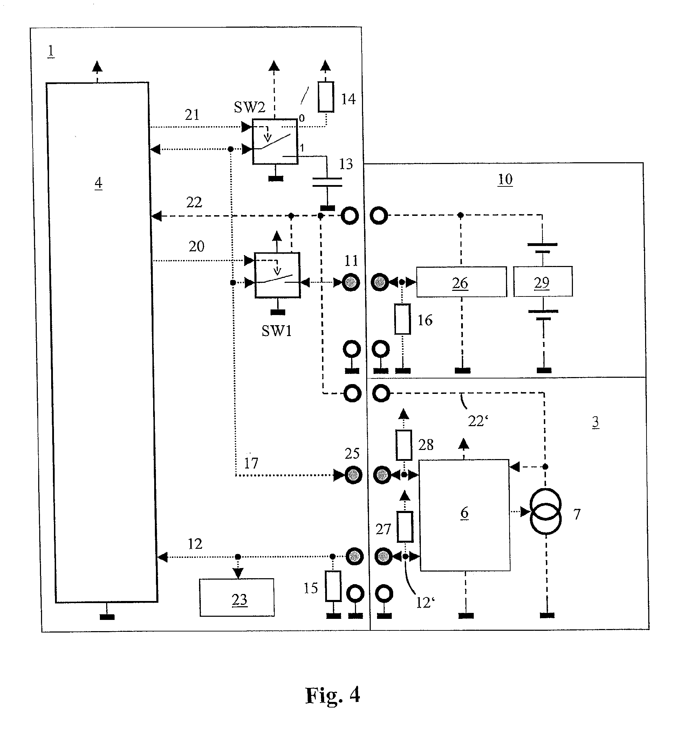

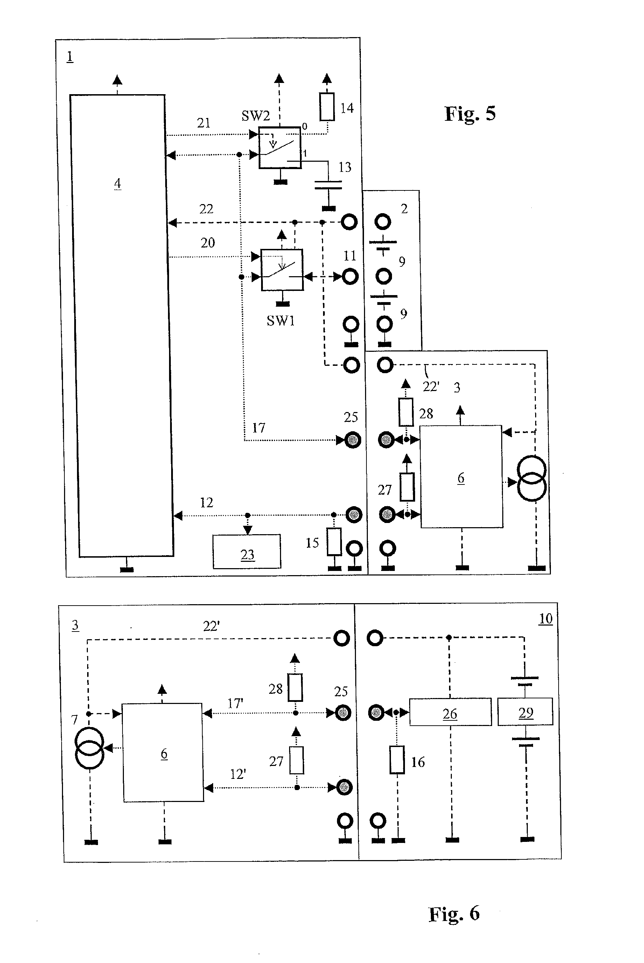

Figure 4 shows the situation with battery pack 10 inserted and the charger 3 suspended, i.e., the configuration as in Figure 3, but with the additionally connected charger 3. A voltage incursion on the line device start 12 in device 1 is produced by a pull-down resistor 15 in device 1 and a pull-up resistor 27 in charger 3, which is acknowledged by charger 3, for example, by means of an internal ADC, and which means that device 1 is remote-started by means of an active HIGH - level via a power unit 23, as is further explained below. A pull-up resistor 28 has no relevance in this mode of operation, its function is described later under reference to figure 6.

Figure 5 shows an operation with the batteries 9 inserted in the battery shaft 2 and the charger 3 as a "data interface", which is established by the device regulation electronics by measuring the center voltage and the voltage lying on the line device start 12. The starting procedure is the same as given above under reference to figure 4. The center voltage is switched off by SW1 from the data line 17 of the center contact of the charger 3. Between device 1 and charger 3, undisturbed data exchange occurs on the line. SW2 switches on the pull-up resistor 14 so that the open-collector-bus system is switched to the HIGH-level. The capacitor 13, as explained above, serves as a buffer for the ADC and is switched off to avoid the delay of the data protocol produced by it.

Figure 6 shows the charger 3 with a battery pack 10 inserted into battery shaft 2'. The charger of regulation electronics 6 recognizes contact of the battery pack 10 by the change in voltage on the line "charge plus" 22'. Since no device 1 is contacted, its pull-up resistor 14 is missing, for which reason a pull-up resistor 28 is provided in the data line 17', which does not interfere in the other types of operation. The line device-start 12' is not contacted.

The individual operating parameters significant for the invention are now checked by device 1 during engagement, and subsequently in a periodic manner, to determine whether a charger is connected. Other operating parameters such as: dead batteries 9, empty battery shaft 2, etc., are checked in the usual manner according to the prior art and require no further explanation here. During checking, the following occur:
I) If the line DEVICE START 12 is LOW at start, switch SW1 is closed and switch SW2 is connected with the capacitor 13 by orders received via command lines 20 and 21 and the device measures the center voltage at center voltage line 11 and reacts as a function of the measurement result:
   A) If the center voltage is less than 0.5 V, the command line 21 is set at LOW, and the operating case of the battery pack, Figure 3, is acknowledged. This is followed by start with the data protocol between the "battery-powered device" 1 and "battery pack" 10.
   B) If the center voltage is greater than 0.5 V, battery operation with two cells 9 is acknowledged and the command line 21 remains on HIGH, the situation as illustrated in Figure 2. This is followed by evaluation of the remaining time via the battery voltage, for example, according to Patent AT 408 280 B (US 6,344,730 A).
II) If the line DEVICE START 12 is HIGH at start, vie the command lines 20 and 21 the switch SW1 is closed and the switch SW2 is connected with the capacitor 13, device measures the center voltage and reacts as a function of the measurement result:
   A) If the center voltage is greater than 2 V, switch SW2 is, by means of command line 21, connected to the pull-up resistor 14, the operating case of the battery pack with charger, Figure 4, is acknowledged. The charger 3 then takes over the master function and the "battery-powered device" 1 switches to the slave mode and waits for commands from the charger 3.
   B) If the center voltage is less than 2 V, battery operation with two cells 9 and the charger 3 is acknowledged; by means of command line 21 switch SW2 is connected with pull-up resistor 14 and by means of command line 20 switch SW1 is opened, the situation is as given in figure 5. The data line between the charger and "battery-powered device" is therefore separated from the center contact so that undisturbed data exchange can occur between the two devices. The charger takes over the master function and the "battery-powered device" changes to the slave mode and waits for commands from the charger.
III) If the line DEVICE START 12 reaches the HIGH state during operation, depending on the type of operation, it is switched from (I-A) to (II-A) or from (I-B) to (II-B), respectively.

The stated limit voltages, through which the individual situations are acknowledged and considered, can be determined or established by corresponding dimensioning of the resistors with consideration of the threshold values of the regulation electronics 4, 6 and the leakage currents. Values smaller than 100 kΩ for the pull-up resistors, values greater than 100 kΩ for the pull-down resistors, and a value of less than 10 kΩ for the total series resistors should be chosen at transmission rates of more than 2 ms/bit. If more rapid data transmission is sought, the resistances must be smaller than stated.

The following line definitions must be maintained in order to both acknowledge and execute these types of operation:
In the battery-powered device 1:
   The port of line 22 must be an ADC input; it measures the total voltage of the inserted batteries-storage batteries-battery pack.
   The port of the center voltage line 17 (Figure 1) must be switchable between OUTPUT LOW, INPUT, and ADC MEASUREMENT since it is used, on the one hand, to measure the center voltage and, on the other hand, as an interface to the battery pack 10 or to the charger 3.
   The port of the command line 21 must be switchable between OUTPUT LOW and OUTPUT HIGH and must therefore switch between the operation of battery 9 and operation with battery pack 10.
   The port of command line 20 must be switchable between OUTPUT LOW and OUTPUT HIGH so that the line to the battery center contact 8 (Figure 1) is separated, if necessary, so that communication between device 1 and charger 3 is also possible with the battery inserted.
   The port of line DEVICE START (command connection) 12 must be switched to INPUT in order to acknowledge a possible remote start by charger 3.
In battery pack 10:
   The port of the line DATA 24 (Figure 6) must be switchable between OUTPUT LOW and INPUT in battery pack 10.
In charger 3:
   The port of line DATA 17 must be switchable between OUTPUT LOW and INPUT.
   The port of line DEVICE START (command connection) 12' must be switchable between OUTPUT HIGH, OUTPUT LOW, and ADC MEASUREMENT.
   The port of line "CHARGE PLUS" 22' must be an ADC input; it measures the total voltage of the inserted batteries, storage batteries or battery pack, respectively.

Switch SW1 is a CMOS-switch, working analog, which prevents the emptying of batteries when the device is switched of -- device regulation electronics not supplied -- via the protective diodes of the device regulation electronics. By supplying the total tension of the batteries at the switched off state, the protective diodes went not active. During regular, active use, the supply voltage of SW1 is brought to the working tension.

SW2 is an analog CMOS multiplexer which in battery mode, adds a capacitor 13, needed as buffer for an ADC within the device regulation electronics, and, in battery pack mode, adds a pull-up resistor 14, needed for the bus system, to the circuit.

ON/OFF - CICUIT turns the device 1 on, when the signal line DEVICE START is put to HIGH by charger 3. This may be achieved by a npn-transistor which switches through a P-channel-MOSFET.

## Claims

1. Battery-powered device (1) with at least one battery shaft (2) for two batteries (9) or storage batteries having device regulation electronics (4) to determine and display the state of charging of the batteries (9) or storage batteries inserted in the battery shaft, in which a center contact (8) is provided in battery shaft (2), which is used to measure the individual voltages of batteries (9) or storage batteries, **characterized in that**, during the use of a battery pack (10) having regulation electronics (26), data transfer occurs with the battery-powered device (1) via center contact (8).

2. Battery-powered device according to Claim 1, **characterized in that** in addition to the battery shaft (2), it has an additional connection unit (25) for connection with a charger (3) having charger regulation electronics (6).

3. Battery-powered device according to Claim 2, **characterized in that** the additional connection unit (25) creates a command connection (12) between the charger regulation electronics (6) and the device regulation electronics (4).

4. Battery-powered device according to any of the preceding claims, **characterized in that** the center contact (8) is connected to the device regulation electronics (4) via a line (11) and a line regulation (5).

5. Battery powered device according to any of the preceding claims, **characterized in that** a switch (SW1) interrupts center connection (11) if connection between battery powered device (1) and charger (3) is established.

6. Battery-powered device according to any of claims 2 to 5, **characterized in that** the command connection (12) has a power unit (23) through which the device (1) can be engaged by the charger (3).

7. Battery powered device according to any of the preceding claims, **characterized in that** a switch (SW2) connects a data line (17) with a pull-up resistor (14) if connection between battery powered device (1) and charger (3) is established.

8. Battery pack for the use with a battery powered device according to any one of the preceding claims, **characterized in that** a fuse (29) is provided between the two storage batteries of the battery pack (10).
